# EUROPEAN PATENT SPECIFICATION

(11) **EP 4 418 325 B1**
(45) Date of publication and mention of the grant of the patent: **25.02.2026**
(21) Application number: 23209421.9
(22) Date of filing: 13.11.2023
(51) Int. Cl.: H10D 30/01, H10D 30/66, H10D 62/10, H10D 64/27

(54) **POWER SEMICONDUCTOR DEVICE**
LEISTUNGSHALBLEITERANORDNUNG
DISPOSITIF SEMI-CONDUCTEUR DE PUISSANCE

(30) Priority: 16.02.2023 KR 20230020741
(43) Date of publication of application: 21.08.2024
(73) Proprietor: Hyundai Mobis Co., Ltd., Gangnam-gu Seoul 06141 (KR)
(72) Inventor: LEE, Ju Hwan, 16891 Yongin-si, Gyeonggi-do (KR)
(74) Representative: Frenkel, Matthias Alexander

(56) References cited:
- CN-A- 111 933 685
- US-A- 5 907 169
- US-A1- 2016 225 905
- US-A1- 2017 092 743
- US-B2- 8 860 039
- US-B2- 8 987 817

## Description

### BACKGROUND

### 1. Field

Embodiments of the present disclosure relate to a semiconductor device, and more particularly, to a power semiconductor device for switching power transmission.

### 2. Description of the Related Art

A power semiconductor device is a semiconductor device operating in a high voltage and high current environment. The power semiconductor device is used in fields requiring high power switching, for example, power conversion systems, power converters, inverters, etc. For example, the power semiconductor device may include an insulated gate bipolar transistor (IGBT), a power MOSFET, and the like. The power semiconductor device basically requires withstand characteristics for high voltage, and recently, additionally, a high-speed switching operation.

Accordingly, research on power semiconductor devices using silicon carbide (SiC) instead of conventional silicon (Si) has been conducted. Silicon carbide (SiC) is a wide-gap semiconductor material with a higher band gap than silicon, and can maintain stability even at high temperature compared to silicon. Furthermore, since silicon carbide has a very high dielectric breakdown field compared to silicon, silicon carbide can stably operate even at high voltage compared to silicon. Therefore, silicon carbide has a higher breakdown voltage than silicon and excellent heat dissipation so that the silicon carbide can operate at high temperature.

In order to increase the channel density of a power semiconductor device using silicon carbide (SiC), a trench-type gate structure having a vertical channel structure has been intensively researched and proposed. US 8 987 817 B2 discloses a semiconductor device including a semiconductor substrate of a first conductive type, an epitaxial layer of the first conductive type formed on the semiconductor substrate and having a protrusion formed on a surface thereof, a well region of a second conductive type formed on the surface of the epitaxial layer at each side of the protrusion, a source region of the first conductive type selectively formed in a surface of the well region, a gate insulating film formed so as to cover at least the protrusion and the surface of the well region, and a gate electrode formed on a part of the gate insulating film corresponding to the protrusion. US 2017/092743 A1 discloses a method for producing a semiconductor power device, which includes forming a gate trench from a surface of a semiconductor layer toward an inside thereof, forming a first insulation film on an inner surface of the gate trench, removing a part on a bottom surface of the gate trench in the first insulation film, forming a second insulation film having a dielectric constant higher than SiO2 in such a way as to cover the bottom surface of the gate trench exposed by removing the first insulation film. CN 111 933 685 A discloses a cellular structure of a silicon carbide MOSFET device, a preparation method of the cellular structure and the silicon carbide MOSFET device, wherein the cellular structure comprises a first conductive type drift layer located above a substrate, side grooves downwards formed in the positions, at the two sides of the cellular structure, of the surface of the drifting layer, so that a boss is formed in the center of the cellular structure, of the surface of the drifting layer, a second conductive type well region positioned under the side grooves, a first conductive type source region positioned in the surface of the well region, and a second conductive type shielding region arranged in the drift layer and is positioned under the top and the side wall of the boss and the side, close to the boss, of the bottom of the side groove. US 2016/225905 A1 discloses a silicon carbide semiconductor device including a trench partially formed in a surface layer of an epitaxial layer, a well layer formed along side surfaces and a bottom surface of the trench, a source region formed in a surface layer of the well layer on the bottom surface of the trench, a gate insulating film, and a gate electrode, wherein the gate insulating film is formed along the side surfaces of the trench and has one end formed so as to reach the source region, and the gate electrode is formed along the side surfaces of the trench and formed on the gate insulating film. US 5 907 169 A discloses a MOSFET transistor supported on a substrate, including an epitaxial-layer of a first conductivity type near a top surface of the substrate defining a drain region therein, an oxide block supported on a raised silicon terrace of the epitaxial layer disposed in a central portion of the transistor above a JFET reduction region of a first conductivity type of higher dopant concentration than the epitaxial layer, a lower-outer body region of a second conductivity type surrounding the JFET reduction region disposed near the top surface and defining a boundary of the MOSFET transistor, a source region of the first conductivity type enclosed in the lower-outer body region disposed near the top surface and extended to the transistor boundary, a thin gate oxide layer overlying the top surface of the substrate and an edge of the raised oxide terrace, a polysilicon gate overlaying the oxide block and the silicon terrace, the gate further covering an area above the source region and the body region insulated by the gate oxide layer therefrom.

### SUMMARY

The invention is defined by the appended claims.

### BRIEF DESCRIPTION OF THE DRAWINGS

FIG. 1 is a cross-sectional view schematically showing a power semiconductor device according to one embodiment of the present disclosure useful to understand the present invention.
FIGS. 2A to 2C are cross-sectional views schematically showing example processes of forming the structure of FIG. 1 according to one embodiment of the present disclosure useful to understand the present invention.
FIG. 3 is a cross-sectional view showing a power semiconductor device according to another embodiment of the present disclosure according to the present invention.
FIGS. 4A and 4B are cross-sectional views schematically showing examples of a power semiconductor device according to other embodiments of the present disclosure according to the present invention.
FIG. 5 is a cross-sectional view schematically showing a power semiconductor device according to another embodiment of the present disclosure not forming part of the present invention.
FIG. 6 is a cross-sectional view schematically showing a power semiconductor device according to another embodiment of the present disclosure not forming part of the present invention.

Throughout the drawings and the detailed description, unless otherwise described or provided, the same, or like, drawing reference numerals may be understood to refer to the same, or like, elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. For example, the sequences of operations described herein are merely examples, and are not limited to those set forth herein, but may be changed as will be apparent after an understanding of the disclosure of this application, with the exception of operations necessarily occurring in a certain order.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Advantages and features of the present disclosure and methods of achieving the advantages and features will be clear with reference to embodiments described in detail below together with the accompanying drawings. However, the present disclosure is not limited to the embodiments disclosed herein but will be implemented in various forms. The embodiments of the present disclosure are provided so that the present disclosure is completely disclosed, and a person with ordinary skill in the art can fully understand the scope of the present disclosure. The present disclosure will be defined only by the scope of the appended claims. Meanwhile, the terms used in the present specification are for explaining the embodiments, not for limiting the present disclosure.

Terms, such as first, second, A, B, (a), (b) or the like, may be used herein to describe components. Each of these terminologies is not used to define an essence, order or sequence of a corresponding component but used merely to distinguish the corresponding component from other component(s). For example, a first component may be referred to as a second component, and similarly the second component may also be referred to as the first component.

Throughout the specification, when a component is described as being "connected to," or "coupled to" another component, it may be directly "connected to," or "coupled to" the other component, or there may be one or more other components intervening therebetween. In contrast, when an element is described as being "directly connected to," or "directly coupled to" another element, there can be no other elements intervening therebetween.

In a description of the embodiment, in a case in which any one element is described as being formed on or under another element, such a description includes both a case in which the two elements are formed in direct contact with each other and a case in which the two elements are in indirect contact with each other with one or more other elements interposed between the two elements. In addition, when one element is described as being formed on or under another element, such a description may include a case in which the one element is formed at an upper side or a lower side with respect to another element.

The singular forms "a", "an", and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

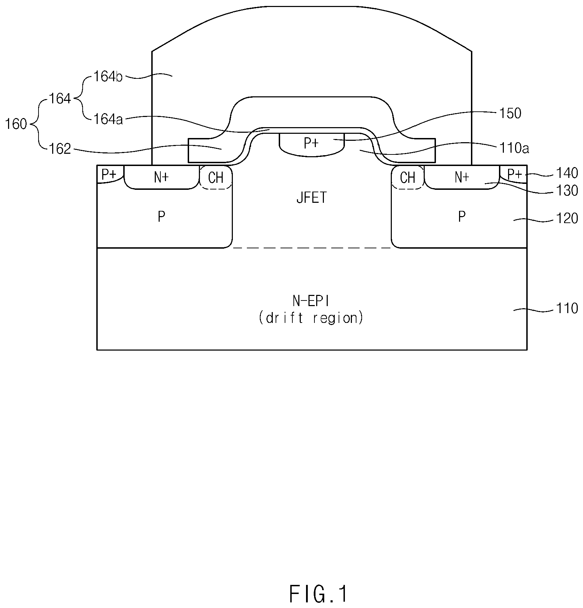

FIG. 1 is a cross-sectional view showing a power semiconductor device according to one embodiment of the present disclosure useful to understand the present invention.

Referring to FIG. 1, the power semiconductor device includes a semiconductor layer 110, well region 120, source region 130, well contact region 140, a shielding region 150, and a gate 160.

The semiconductor layer 110 may include one or multiple semiconductor material layers. For example, the semiconductor layer 110 may include one or multiple epitaxial layers. The semiconductor layer 110 may include one or multiple epitaxial layers on a semiconductor substrate. For example, the semiconductor layer 110 may include a silicon carbide (SiC) substrate. Alternatively, the semiconductor layer 110 may include at least one SiC epitaxial layer grown on the SiC substrate. The semiconductor layer 110 may include a drift region into which impurities of the first conductivity type (e.g., N-type) are implanted. The semiconductor layer 110 may include an epitaxial layer formed of silicon carbide (SiC) (hereinafter referred to as 'SiC epitaxial layer') implanted with impurities of the first conductivity type (hereinafter referred to as 'first conductive impurities'). The semiconductor layer 110 may provide a movement path of a current during operation of the power semiconductor device.

Silicon carbide (SiC) has a larger band gap than silicon (Si), so that the silicon carbide can maintain stability even at high temperature compared to silicon. Furthermore, silicon carbide (SiC) has a very high dielectric breakdown field compared to silicon, so that the silicon carbide can operate stably even at high voltage. Therefore, the power semiconductor device designed to use silicon carbide (SiC) as a semiconductor layer 110 has a higher breakdown voltage and more excellent heat dissipation characteristics than the other power semiconductor device in which silicon instead of silicon carbide is used, and can exhibit stable operation characteristics even at high temperature.

The semiconductor layer 110 includes a protrusion 110a protruding from a lower portion of the gate 160 to a predetermined height. For example, a top surface of the semiconductor layer 110 may have a stepped shape (i.e., a step) formed in a manner that a region between the well regions 120 in the semiconductor layer 110 protrudes farther upward than other regions. The length (width) of the protrusion 110a may be shorter than the length (width) of the gate electrode layer 162 such that the protrusion 110a can be covered by a gate electrode layer 162. In this case, an edge region of the protrusion 110a covered by the gate electrode layer 162 may be rounded to have a curvature. Particularly, a region (i.e., a stepped region) where a step is formed may be rounded to have a curvature.

A junction field effect transistor (JFET) region is formed in an upper region of the semiconductor layer 110. For example, a JFET region for improving conduction characteristics may be formed as a charge storage structure in a region between adjacent well regions 120 in the semiconductor layer 110. The JFET region 180 includes the first conductivity-type impurities having a higher concentration than a region (i.e., a drift region) located under the JFET region 180. The drift region is distributed with impurities of the first conductivity type at a concentration of N-, and the JFET region is distributed with impurities of the first conductivity type at a concentration of N.

Although FIG. 1 shows that the bottom surface of the JFET region is located at the same level as the bottom surface of the well region 120 for convenience of description, the scope of the present disclosure is not limited thereto.

A drain electrode (not shown) is formed below the semiconductor layer 110. The drain electrode may include a conductive material such as metal.

When an operation voltage is applied to the gate electrode layer 162, the well region 120 may form a channel (CH) through which a current can flow between the JFET region of the semiconductor layer 110 and the source region 130. The well region 120 may be formed in the semiconductor layer 110 to be in contact with the top surface of the semiconductor layer 110. For example, the well region 120 is located at both sides of the protrusion 110a in the semiconductor layer 110, and a portion of the well region 120 is disposed below the gate to overlap the gate electrode layer 162 so that a channel (CH) can be formed in the corresponding region. The well region 120 includes impurities of a second conductivity type (e.g., P-type) opposite to the first conductivity type.

The source region 130 is formed in the well region 120 to contact the top surface of the semiconductor layer 110. For example, the source region 130 may be located in the well region 120 such that a portion of the source region 130 can overlap both ends of the gate electrode 162. A partial region of the top surface of the source region 130 may be covered by the gate 160, and the other partial region of the top surface of the source region 130 may be exposed outside without being covered by the gate 160 so that the other partial region can contact the source electrode (not shown). The source region 130 may include the first conductivity-type impurities having a higher concentration than the semiconductor layer 110.

The well contact region 140 is formed in the well region 120 to contact the top surface of the semiconductor layer 110. The well contact region 140 may be formed to be in contact with a source electrode (not shown), thereby supplying a source potential to the well region 120. The well contact region 140 may include impurities of the second conductivity type at a higher concentration than the well region 120.

The shielding region 150 is formed to contact a gate insulation layer 164 within the protrusion 110a of the semiconductor layer 110. The shielding region 150 may be formed to cover a center portion of the gate insulation layer 164 within the protrusion 110a. The shielding region 150 may include impurities of the second conductivity type (i.e., P-type) having high concentration (P+).

Although FIG. 1 shows an example case in which the shielding region 150 covers only the center portion of the gate insulation layer 164 within the protrusion 110a for convenience of description, the scope of the present disclosure is not limited thereto, and it should be noted that the shielding region 150 entirely covers the top and side surfaces of the protrusion 110a. The shielding region 150 may be electrically connected to a source electrode (not shown) to receive a source potential.

The gate 160 includes the gate electrode layer 162 and the gate insulation layer 164. The gate electrode layer 162 may be formed over the semiconductor layer 110 to entirely cover the protrusion 110a. For example, the gate electrode layer 162 may be formed to extend to a length (width) that may cover some regions of the well regions 120 and the source regions 130 disposed at both sides of the protrusion 110a while entirely covering the protrusion 110a. The gate electrode layer 162 may form a horizontal channel (CH) in regions disposed below the gate electrode layer 162 upon receiving an operation voltage. The gate electrode layer 162 may include polysilicon or metal into which impurities are implanted.

The gate insulation layer 164 may be formed to surround the gate electrode layer 162. The gate insulation layer 134 may include a lower gate insulation layer 164a and an upper gate insulation layer 164b. The lower gate insulation layer 164a may represent a region formed between the gate electrode layer 162 and the semiconductor layer 110 in the gate insulation layer 164. The upper gate insulation layer 164b may represent a region that covers the top and side surfaces of the gate electrode layer 162 in the gate insulation layer 164. The gate insulation layer 164 may include an insulating material such as silicon oxide, silicon carbide oxide, silicon nitride, hafnium oxide, zirconium oxide, or aluminum oxide, or may include a stacked structure thereof.

A source electrode (not shown) may be formed on the semiconductor layer 110 and the gate 160 to contact the source region 130 and the well contact region 140.

When the operation voltage is applied to the gate electrode layer 162, an electric field may be concentrated at a lower surface of the gate electrode layer 162. When the electric field is concentrated at the lower surface of the gate electrode layer 162, the gate insulation layer 164 in the corresponding region is subjected to severe stress, which may cause dielectric breakdown of the gate insulation layer 164. Therefore, the lower surface of the gate insulation layer 164 may be surrounded by the impurity region (i.e., the shielding region) 150 of a type (i.e., P-type) opposite to the impurity type (N-type) of the semiconductor layer 120, thereby preventing dielectric breakdown of the gate insulation layer 164.

However, when the top surface of the semiconductor layer 110 is planarized and the shielding region is formed by implanting high-concentration impurities of the second conductivity type into a lower portion of the gate insulation layer, the shielding region may interfere with the flow of a current.

In the present embodiment, after the semiconductor layer 110 formed between the well regions 120 protrudes upward to a predetermined height, the shielding region 150 is formed at the protrusion portion 110a so that the flow of current can be facilitated and dielectric breakdown of the gate insulation layer 164 can be prevented.

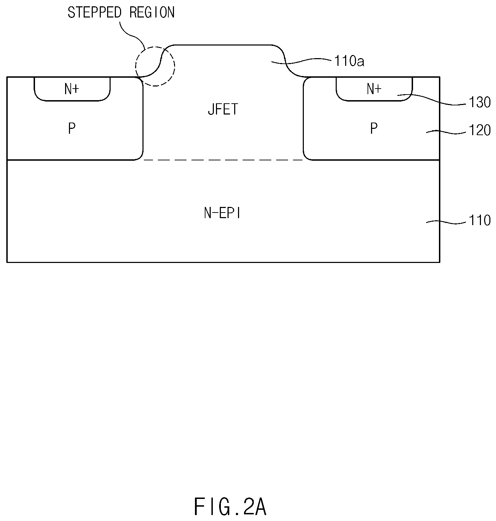

FIGS. 2A to 2C are cross-sectional views schematically showing example processes of forming the structure of FIG. 1 according to one embodiment of the present disclosure useful to understand the present invention.

Referring to FIG. 2A, a portion of an upper region of the semiconductor layer 110 may be partially etched to form a protrusion 110a in which an unetched region of the semiconductor layer 110 protrudes upward. For example, the protrusion 110a may be formed in the semiconductor layer 110 between the adjacent well regions 120 by etching a region where the well region 120 is to be formed in a subsequent process.

In this case, the protrusion 110a may be formed through a key etch process or a trench etch process so that a region (i.e., a stepped region) where a stepped shape is formed at the top surface of the semiconductor layer 110 has a curvature.

Subsequently, the well region 120 may be formed by implanting impurities of the second conductivity type into regions adjacent to both sides of the protrusion 110a, and impurities of the first conductivity type may be implanted into the upper region of the well region 120 to form the source region 130.

In a region between adjacent well regions 120 in the semiconductor layer 110, a JFET region in which impurities of the first conductivity type are implanted with a higher concentration than an underlying region (i.e., a drift region) can be formed. The JFET region may be formed before or after the well region 120 is formed.

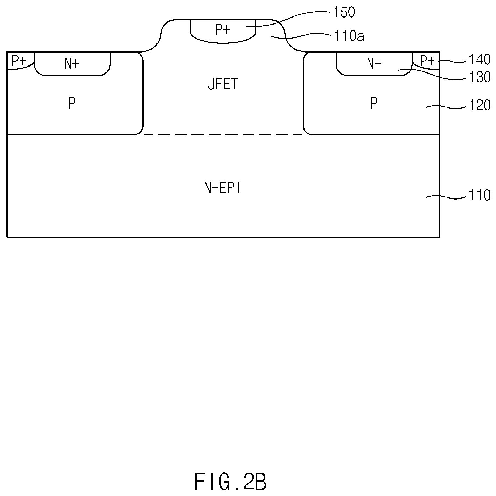

Referring next to FIG. 2B, the shielding region 150 and the well contact region 140 may be formed by implanting high-concentration impurities (P+-type impurities) of the second conductivity type into the protrusion 110a and the well region 120. For example, the shielding region 150 may be formed at the center portion of the protrusion 110a to contact the top surface of the protrusion 110a, and the well contact region 140 may be formed next to the source region 130 so as to be in contact with the top surface of the semiconductor layer 110.

Subsequently, a thermal annealing process may be performed on the semiconductor layer 110 in which the impurity regions (120, 130, 140, 150) are formed, so that the implanted impurities can be activated.

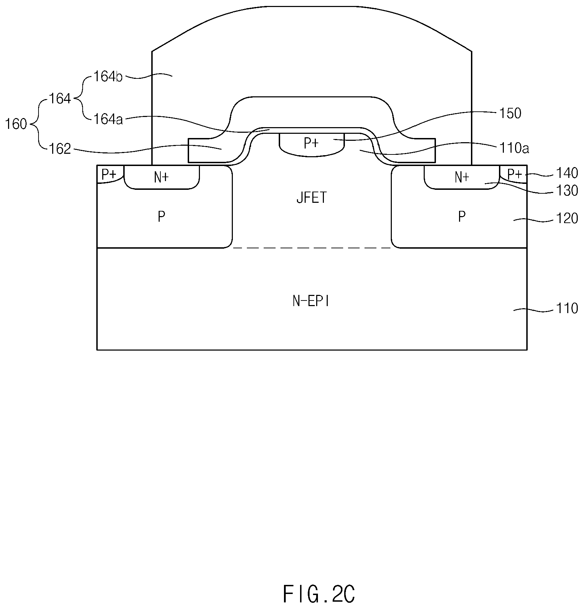

Referring to FIG. 2C, a gate 160 may be formed on the semiconductor layer 110a including the protrusion 110a.

For example, after an insulation layer is formed on the semiconductor layer 110a and a conductive material for the gate (hereinafter referred to as a gate conductive material) is formed on the insulation layer, the gate conductive material may be patterned, resulting in formation of the gate electrode layer 162. In this case, the insulation layer formed below the gate electrode layer 162 may be used as a lower gate insulation layer 164a.

Subsequently, after the insulation layer is formed entirely over the gate electrode layer 162 and the semiconductor layer 110, the insulation layer may be patterned to expose the well contact region 140 and a portion of the source region 130, resulting in formation of an upper gate insulation layer 164b.

Then, a source electrode (not shown) may be formed on the semiconductor layer 110 and the gate 160 to contact the source region 130 and the well contact region 140, and a drain electrode (not shown) is formed below the semiconductor layer 110.

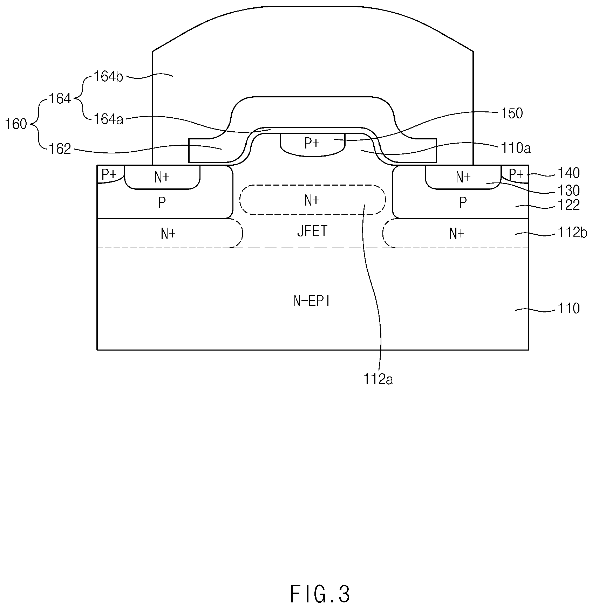

FIG. 3 is a cross-sectional view showing a power semiconductor device according to another embodiment of the present disclosure.

Referring to FIG. 3, in the power semiconductor device according to the present embodiment, impurities of the first conductivity type are additionally implanted into the semiconductor layer 110 in a stepwise manner, so that a high-concentration impurity region 112 can be formed in a stepped shape.

For example, impurities of the first conductivity type are implanted adjacent to the lower region of the well region 122 and the JFET region to form the impurity regions 112a and 112b, such that the depth of the well region 122 can be reduced and ON-resistance (Rdson) of the JFET region can also be reduced. Each of the impurity regions 112a and 112b may have a higher N+ concentration than the JFET region.

In the present embodiment, a portion of the upper region of the semiconductor layer 110 protrudes upward such that the top surface of the semiconductor layer 110 can be formed in a stepped shape. As a result, when the first conductivity-type impurities are implanted into the entire top surface of the stepped semiconductor layer 110 under the same conditions, the impurity regions 112a and 112b can be formed in a stepped shape as shown in FIG. 3. For example, the impurity region 112b disposed below the well region 122 may be formed at a lower position than the impurity region 112a formed in the JFET region by a height of the protrusion 110a.

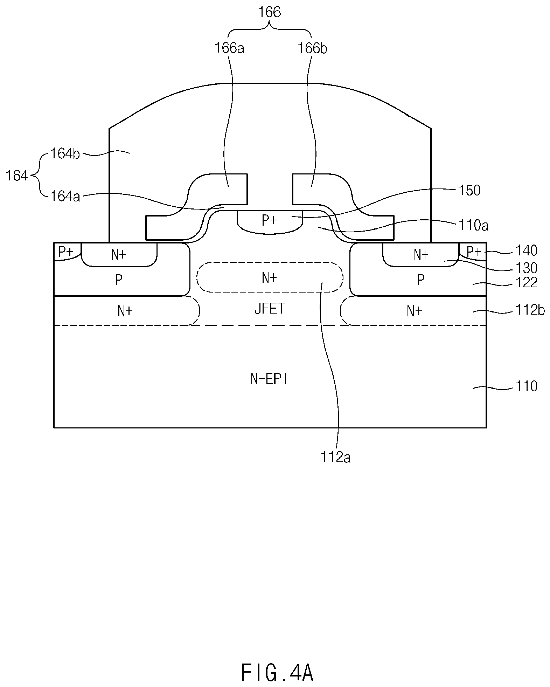

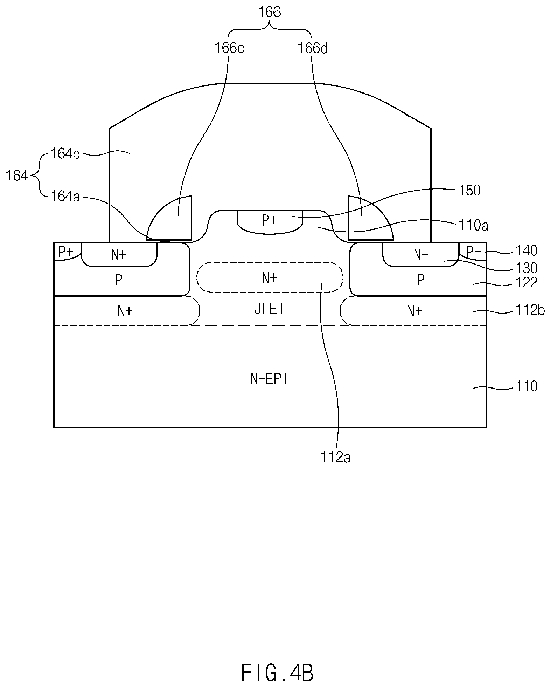

FIGS. 4A and 4B are cross-sectional views schematically showing examples of a power semiconductor device according to other embodiments of the present disclosure.

Referring to FIGS. 4A and 4B, the power semiconductor device according to the present embodiment may include a gate electrode layer 166 that exposes at least a portion of the protrusion 110a without covering the portion of the protrusion 110a. For example, the gate electrode layer 166 may include a plurality of sub-gate electrodes (166a, 166b) isolated from each other such that a partial region (i.e., a center portion) of the top surface of the protrusion 110a is exposed as shown in FIG. 4A, or may include a plurality of sub-gate electrodes (166c, 166d) isolated from each other such that the entire top surface of the protrusion 110a is exposed as shown in FIG. 4B.

The isolated sub-gate electrodes (166a ~ 166b or 166c ~ 166d) may be located symmetrical to each other with respect to the center of the protrusion 110a. The distance between the isolated sub-gate electrodes (166a ~ 166b or 166c ~ 166d) may be adjusted as needed.

As such, since the gate electrode layers 166 are isolated from each other such that a conductive material is not formed in at least a portion of the protrusion 110a, capacitance to be generated by the conductive material can be controlled.

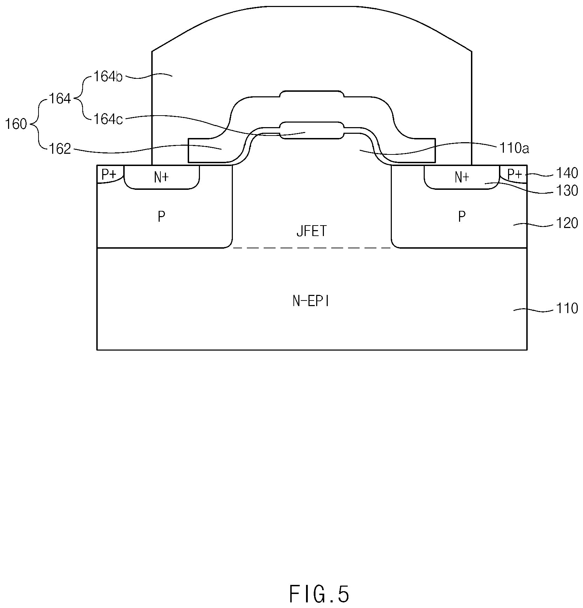

FIG. 5 is a cross-sectional view schematically showing a power semiconductor device according to another embodiment of the present disclosure not forming part of the present invention.

Referring to FIG. 5, the power semiconductor device according to the present embodiment may include a gate insulation layer 164c formed to be partially thick. For example, instead of forming the shielding region 150, the gate insulation layer 164c of the corresponding region is formed relatively thick, thereby preventing dielectric breakdown of the gate insulation layer 164 from being easily generated in the corresponding region.

In the power semiconductor device of FIG. 5, impurity regions (112a, 112b) may be formed to be stepped as in the above-described embodiment of FIG. 3. Also, as in the embodiment of FIG. 4A or 4B, the gate electrode layer 162 may be formed to be isolated from other layers.

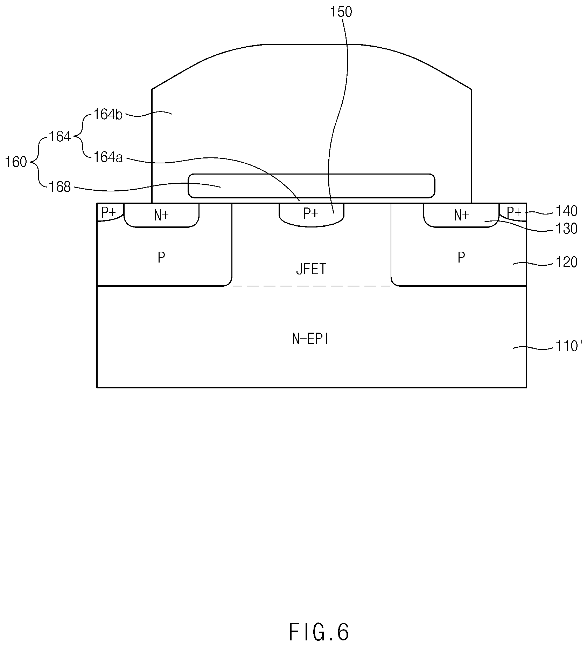

FIG. 6 is a cross-sectional view schematically showing a power semiconductor device according to another embodiment of the present disclosure not forming part of the invention.

Referring to FIG. 6, unlike the above-described embodiments, the power semiconductor device according to the present embodiment may include a shielding region 150 that is disposed below the gate insulation layer 164a such that the shielding region 150 can contact the gate insulation layer 164a in a state in which a protrusion is not formed on the semiconductor layer 110'.

In the power semiconductor device of FIG. 6, impurity regions (112a, 112b) may be formed to be stepped as in the above-described embodiment of FIG. 3. Also, as in the embodiment of FIG. 4A or 4B, the gate electrode layer 162 may be formed to be isolated from other layers.

As is apparent from the above description, the power semiconductor device according to the embodiments of the present disclosure can stably protect a lower portion of a gate by mitigating concentration of an electric field applied to the lower portion of the gate while increasing mobility.

Various embodiments of the present disclosure do not list all available combinations but are for describing a representative aspect of the present disclosure, and descriptions of various embodiments may be applied independently or may be applied through a combination of two or more.

## Claims

1. A power semiconductor device, comprising:
a semiconductor layer (110) having a first conductivity type and configured to include a protrusion (110a) formed from an upper region of the semiconductor layer (110) to protrude upward;
a source electrode formed on the semiconductor layer (110);
a drain electrode formed below the semiconductor layer (110);
a shielding region (150), having a second conductivity type opposite to the first conductivity type, disposed within the protrusion (110a), and configured to contact a top surface of the protrusion (110a);
a gate insulation layer (164a) disposed on the semiconductor layer (110) and configured to cover the protrusion (110a) and to be in contact with the shielding region (150);
a gate electrode layer (162) disposed on the gate insulation layer (164a),
a well region (120) having the second conductivity type and disposed on at least one side of the protrusion (110a) within the semiconductor layer (110), wherein the well region (120) is formed to be in contact with a top surface of the semiconductor layer (110);
a source region (130) having the first conductivity type and disposed in the well region (120) and configured to contact the top surface of the semiconductor layer (110); and
a well contact region (140) having the second conductivity type and disposed at one side of the source region (130) within the well region (120) and configured to contact the top surface of the semiconductor layer (110),
wherein the source electrode contacts the source region (130) and the well contact region (140),
wherein the semiconductor layer (110) comprises:
a drift region (N-EPI) comprising impurities of the first conductivity type, the impurities being distributed at a first concentration of N-; and
a junction field effect transistor (JFET) region comprising the impurities of the first conductivity type being distributed at a second concentration of N, the second concentration being greater than the first concentration, the JFET region being disposed on the drift region;
a first impurity region (112a) disposed in the JFET region and configured to have a third concentration of N+ of the first conductivity type, and the third concentration being greater than the second concentration.

2. The power semiconductor device according to claim 1, wherein:
the gate electrode layer (162) extends to cover a partial region of the source region while entirely covering the protrusion.

3. The power semiconductor device according to claim 1, wherein the gate electrode layer comprises:
a plurality of sub-gate electrodes (166a-166d) isolated from each other and configured to expose at least a portion of the protrusion.

4. The power semiconductor device according to claim 3, wherein:
the plurality of sub-gate electrodes (166a-166d) are disposed symmetrically with each other with respect to a center portion of the protrusion.

5. The power semiconductor device according to claim 1, wherein the semiconductor layer further comprises:
a second impurity region (112b) including the third concentration of the first conductivity type disposed on at least one side of the first impurity region and arranged lower than the first impurity region by a height of the protrusion.

## Patentansprüche

1. Leistungshalbleitervorrichtung, umfassend:
eine Halbleiterschicht (110), die einen ersten Leitfähigkeitstyp aufweist und dazu eingerichtet ist, einen Vorsprung (110a) zu enthalten, der aus einem oberen Bereich der Halbleiterschicht (110) gebildet ist, um nach oben vorzustehen;
eine Source-Elektrode, die auf der Halbleiterschicht (110) gebildet ist;
eine Drain-Elektrode, die unterhalb der Halbleiterschicht (110) gebildet ist;
einen Abschirmbereich (150), der einen zweiten Leitfähigkeitstyp entgegengesetzt zum ersten Leitfähigkeitstyp aufweist, innerhalb des Vorsprungs (110a) angeordnet ist und dazu eingerichtet ist, mit einer oberen Fläche des Vorsprungs (110a) in Kontakt zu stehen;
eine Gate-Isolationsschicht (164a), die auf der Halbleiterschicht (110) angeordnet ist und dazu eingerichtet ist, den Vorsprung (110a) zu bedecken und in Kontakt mit dem Abschirmbereich (150) zu stehen;
eine Gate-Elektrodenschicht (162), die auf der Gate-Isolationsschicht (164a) angeordnet ist;
einen Well-Bereich (120), der den zweiten Leitfähigkeitstyp aufweist und auf mindestens einer Seite des Vorsprungs (110a) innerhalb der Halbleiterschicht (110) angeordnet ist, wobei der Well-Bereich (120) so gebildet ist, dass er in Kontakt mit einer oberen Fläche der Halbleiterschicht (110) steht;
einen Source-Bereich (130), der den ersten Leitfähigkeitstyp aufweist, im Well-Bereich (120) angeordnet ist und dazu eingerichtet ist, mit der oberen Fläche der Halbleiterschicht (110) in Kontakt zu stehen; und
einen Well-Kontaktbereich (140), der den zweiten Leitfähigkeitstyp aufweist, auf einer Seite des Source-Bereichs (130) innerhalb des Well-Bereichs (120) angeordnet ist und dazu eingerichtet ist, mit der oberen Fläche der Halbleiterschicht (110) in Kontakt zu stehen,
wobei die Source-Elektrode mit dem Source-Bereich (130) und dem Well-Kontaktbereich (140) in Kontakt steht,
wobei die Halbleiterschicht (110) umfasst:
einen Driftbereich (N-EPI), der Störstellen des ersten Leitfähigkeitstyps umfasst, wobei die Störstellen mit einer ersten Konzentration von N- verteilt sind; und
einen Sperrschicht-Feldeffekttransistor-, JFET-, Bereich, der die Störstellen des ersten Leitfähigkeitstyps umfasst, die mit einer zweiten Konzentration von N verteilt sind, wobei die zweite Konzentration größer ist als die erste Konzentration, wobei der JFET-Bereich auf dem Driftbereich angeordnet ist;
einen ersten Störstellenbereich (112a), der im JFET-Bereich angeordnet ist und dazu eingerichtet ist, eine dritte Konzentration von N+ des ersten Leitfähigkeitstyps aufzuweisen, und wobei die dritte Konzentration größer ist als die zweite Konzentration.

2. Leistungshalbleitervorrichtung nach Anspruch 1, wobei:
sich die Gate-Elektrodenschicht (162) so erstreckt, dass sie einen Teilbereich des Source-Bereichs bedeckt, während sie den Vorsprung vollständig bedeckt.

3. Leistungshalbleitervorrichtung nach Anspruch 1, wobei die Gate-Elektrodenschicht umfasst:
eine Mehrzahl von Sub-Gate-Elektroden (166a-166d), die voneinander isoliert sind und dazu eingerichtet sind, mindestens einen Abschnitt des Vorsprungs freizulegen.

4. Leistungshalbleitervorrichtung nach Anspruch 3, wobei:
die Mehrzahl von Sub-Gate-Elektroden (166a-166d) symmetrisch zueinander in Bezug auf einen Mittelabschnitt des Vorsprungs angeordnet ist.

5. Leistungshalbleitervorrichtung nach Anspruch 1, wobei die Halbleiterschicht ferner umfasst:
einen zweiten Störstellenbereich (112b), der die dritte Konzentration des ersten Leitfähigkeitstyps enthält, auf mindestens einer Seite des ersten Störstellenbereichs angeordnet ist und um eine Höhe des Vorsprungs tiefer angeordnet ist als der erste Störstellenbereich.

## Revendications

1. Dispositif à semi-conducteur de puissance, comprenant:
une couche semi-conductrice (110) ayant un premier type de conductivité et conçue pour comprendre une saillie (110a) dans une région supérieure de la couche semi-conductrice (110) pour qu'elle fasse saillie vers le haut;
une électrode source formée sur la couche semi-conductrice (110);
une électrode de drain formée sous la couche semi-conductrice (110);
une région de protection (150) dont le deuxième type de conductivité est opposé au premier type de conductivité, est disposée à l'intérieur de la saillie (110a) et conçue pour entrer en contact avec une surface supérieure de la saillie (110a);
une couche d'isolation de grille (164a) disposée sur la couche semi-conductrice (110) et conçue pour recouvrir la saillie (110a) et être en contact avec la région de protection (150);
une couche d'électrode de grille (162) disposée sur la couche d'isolation de grille (164a),
une région de puits (120) présentant le deuxième type de conductivité et disposée sur au moins un côté de la saillie (110a) à l'intérieur de la couche semi-conductrice (110), la région de puits (120) étant formée de manière à être en contact avec une surface supérieure de la couche semi-conductrice (110);
une région source (130) ayant le premier type de conductivité et disposée dans la région de puits (120) et conçue pour entrer en contact avec la surface supérieure de la couche semi-conductrice (110); et
une région de contact de puits (140) présentant le deuxième type de conductivité et disposée d'un côté de la région source (130) à l'intérieur de la région de puits (120) et conçue pour entrer en contact avec la surface supérieure de la couche semi-conductrice (110),
dans lequel l'électrode source est en contact avec la région source (130) et la région de contact de puits (140),
dans lequel la couche semi-conductrice (110) comprend:
une région de dérive (N-EPI) comprenant des impuretés du premier type de conductivité, les impuretés étant réparties à une première concentration de N-; et
une région de transistor à effet de champ à jonction (JFET) comprenant les impuretés du premier type de conductivité réparties à une deuxième concentration N, la deuxième concentration étant supérieure à la première concentration, la région JFET étant disposée sur la région de dérive;
une première région d'impuretés (112a) disposée dans la région JFET et conçue pour avoir une troisième concentration de N+ du premier type de conductivité, la troisième concentration étant supérieure à la deuxième concentration.

2. Dispositif à semi-conducteur de puissance selon la revendication 1, dans lequel:
la couche d'électrode de grille (162) s'étend pour recouvrir une partie de la région source tout en recouvrant entièrement la saillie.

3. Dispositif à semi-conducteur de puissance selon la revendication 1, dans lequel
une pluralité d'électrodes de sous-grille (166a-166d) isolées les unes des autres et conçues pour mettre en contact une partie de la saillie.

4. Dispositif à semi-conducteur de puissance selon la revendication 3, dans lequel:
les multiples électrodes de sous-grille (166a-166d) sont disposées symétriquement les unes par rapport aux autres par rapport à une partie centrale de la saillie.

5. Dispositif à semi-conducteur de puissance selon la revendication 1, dans lequel
une deuxième région d'impuretés (112b) comprenant la troisième concentration du premier type de conductivité, disposée sur au moins un côté de la première région d'impuretés et agencée à un niveau inférieur que la première région d'impuretés et dont la hauteur correspond à celle de la saillie.
